# EUROPEAN PATENT SPECIFICATION

(11) **EP 4 303 912 B1**
(45) Date of publication and mention of the grant of the patent: **12.03.2025**
(21) Application number: 23181527.5
(22) Date of filing: 26.06.2023
(51) Int. Cl.: H01L 21/60, H01L 23/48, H01L 23/31

(54) **SEMICONDUCTOR DEVICE WITH UNDER-BUMP METALLIZATION AND METHOD THEREFOR**
HALBLEITERBAUELEMENT MIT UNDER-BUMP-METALLISIERUNG UND VERFAHREN DAFÜR
DISPOSITIF SEMI-CONDUCTEUR AVEC MÉTALLISATION SOUS BOSSE ET PROCÉDÉ ASSOCIÉ

(30) Priority: 07.07.2022 US 202217811132
(43) Date of publication of application: 10.01.2024
(73) Proprietor: NXP B.V., 5656 AG Eindhoven (NL)
(72) Inventor: van Gemert, Leo, 5656AG Eindhoven (NL); Zaal, Jeroen Johannes Maria, 5656AG Eindhoven (NL)
(74) Representative: Hardingham, Christopher Mark

(56) References cited:
- US-A1- 2014 264 839

## Description

### Background

### Field

This disclosure relates generally to semiconductor device packaging, and more specifically, to a semiconductor device with under-bump metallization and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability which could impact performance and system costs. Accordingly, significant challenges exist in accommodating these features and applications while minimizing the impact on semiconductor devices' reliability while minimizing impact on performance and costs.

US 2014/264839 A1 discloses a semiconductor die with a bond pad.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 through FIG. 3 illustrate, in simplified cross-sectional views, an example semiconductor device at stages of manufacture in accordance with an embodiment.
FIG. 4A and FIG. 4B illustrate, in simplified plan and corresponding cross-sectional views, the example semiconductor device at a subsequent stage of manufacture in accordance with an embodiment.
FIG. 5A and FIG. 5B illustrate, in simplified plan and corresponding cross-sectional views, the example semiconductor device at an alternative stage of manufacture in accordance with an embodiment.
FIG. 6 through FIG. 8 illustrate, in simplified cross-sectional views, the example semiconductor device at subsequent stages of manufacture in accordance with an embodiment.

### Detailed Description

Generally, there is provided, a semiconductor device with an under-bump metallization (UBM) structure. The semiconductor device includes a semiconductor die partially encapsulated with an encapsulant. An active side of the semiconductor die is exposed and coplanar with a surface of the encapsulant. A non-conductive layer is formed over an active side of semiconductor die and surface of the encapsulant. An opening in the non-conductive layer is formed to expose a bond pad. A laser ablated trench is formed at the surface of the non-conductive layer near a perimeter of the opening. By using a low energy laser to form the trench, a bottom surface of the trench is roughened. The UBM structure is formed by plating over the trench and exposed pad region. The rough texture of the trench allows for superior adhesion of the UBM structure at the trench. By forming the UBM in this manner, potential stress induced delamination is minimized thus improving overall reliability of the semiconductor device.

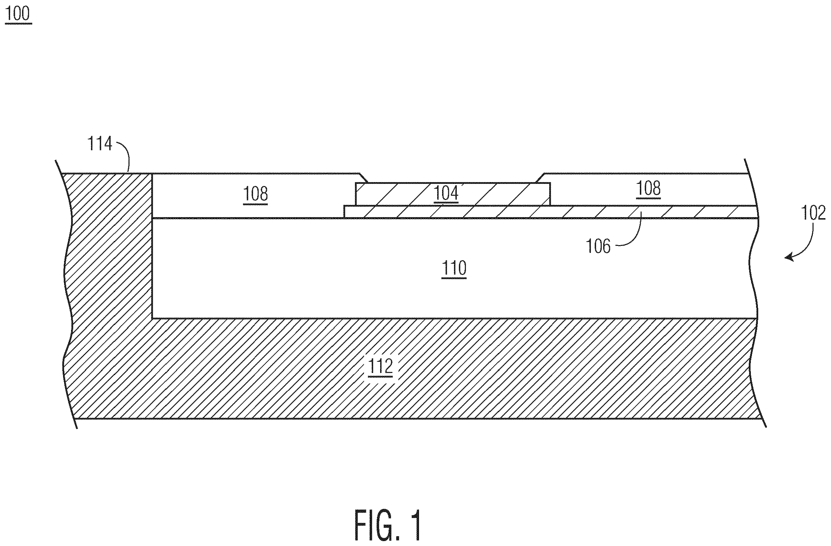

FIG. 1 illustrates, in a simplified cross-sectional view, a portion of an example semiconductor device 100 having a UBM structure at a stage of manufacture in accordance with an embodiment. At this stage of manufacture, the semiconductor device 100 includes a semiconductor die 102 partially encapsulated with an encapsulant 112 such as an epoxy molding compound (EMC). The semiconductor device 100 portion depicted in FIG. 1 through FIG. 8 at stages of manufacture is shown in a bottom side up orientation.

The semiconductor die 102 has an active side (e.g., major side having circuitry) and a backside (e.g., major side opposite of the active side). In this embodiment, the active side of the semiconductor die 102 is exposed (e.g., not encapsulated) and substantially coplanar with a first surface 114 of the encapsulant 112. The semiconductor die 102 includes a substrate (e.g., bulk) portion 110, a conductive interconnect trace 106 (e.g., copper, aluminum, or other suitable metal), a bond pad 104 conductively connected to the trace, and a final passivation layer 108 formed over the active side of the die. The bond pad 104 is configured for conductive connection to printed circuit board (PCB) by way of a UBM structure formed at a subsequent stage, for example. The term "conductive," as used herein, generally refers to electrical conductivity unless otherwise noted.

The semiconductor die 102 may be formed from any suitable semiconductor material, such as silicon, germanium, gallium arsenide, gallium nitride, silicon nitride, silicon carbide, and the like. The semiconductor die 102 may further include any digital circuits, analog circuits, RF circuits, memory, signal processor, MEMS, sensors, the like, and combinations thereof. The semiconductor die 102 may include any number of conductive interconnect layers and passivation layers. For illustration purposes, the interconnect layer forming trace 106 and the final passivation layer 108 are depicted.

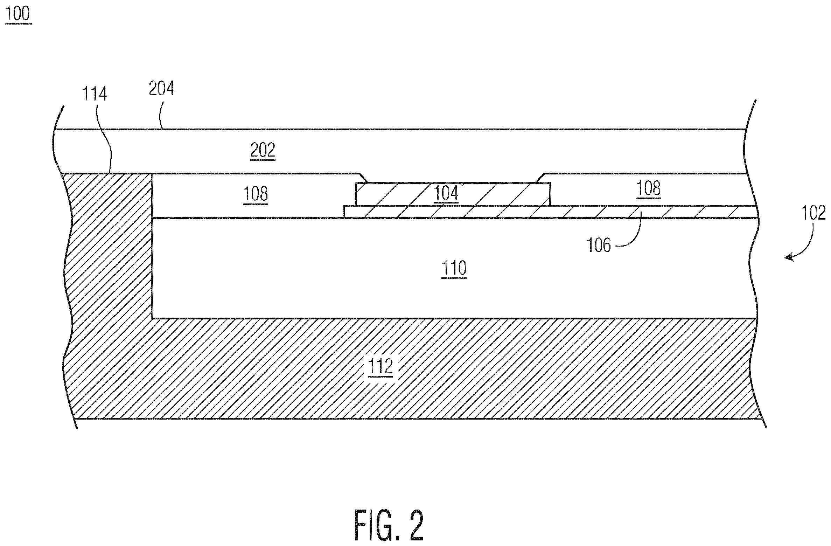

FIG. 2 illustrates, in a simplified cross-sectional view, the example semiconductor device 100 at a subsequent stage of manufacture in accordance with an embodiment. At this stage of manufacture, a non-conductive layer 202 is deposited or otherwise formed over the active side of the semiconductor die 102 and the first surface 114 of the encapsulant 112. The non-conductive layer 202 may be formed from suitable non-conductive materials such as EMC, Ajinomoto build-up film (ABF), photosensitive dielectric material, and the like.

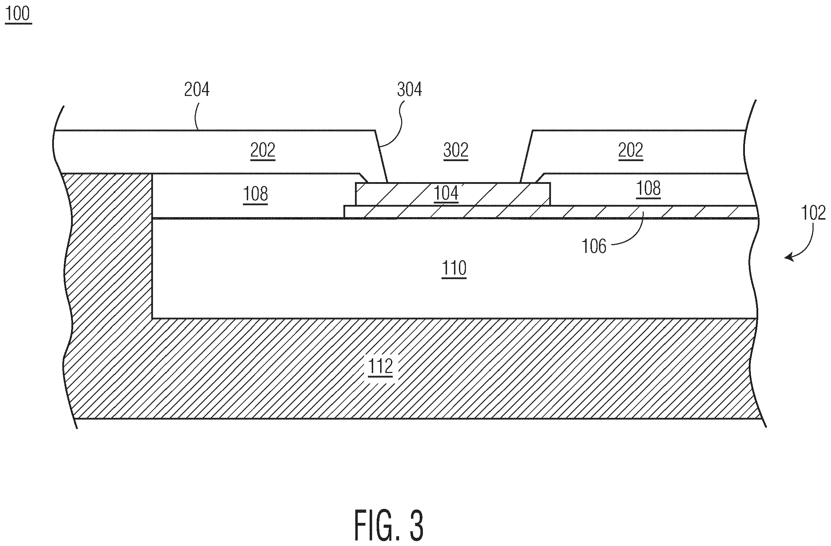

FIG. 3 illustrates, in a simplified cross-sectional view, the example semiconductor device 100 at a subsequent stage of manufacture in accordance with an embodiment. At this stage of manufacture, an opening 302 is formed in the non-conductive layer 202. The opening 302 is formed through the non-conductive layer 202 and located over the bond pad 104 such that a substantial portion of a top surface of the bond pad 104 is exposed. Sidewalls 304 of the opening 302 surround the exposed portion of the bond pad 104 and form a perimeter of the opening. In this embodiment, the opening 302 is formed by way of high energy laser ablation. By forming the opening 302 in this manner, sidewalls of the opening may result with a rough texture thus providing improved adhesion with the UBM structure formed at a subsequent stage, for example. In some embodiments, the opening 302 may be formed by using known mask patterning and wet or dry chemical etch process methods.

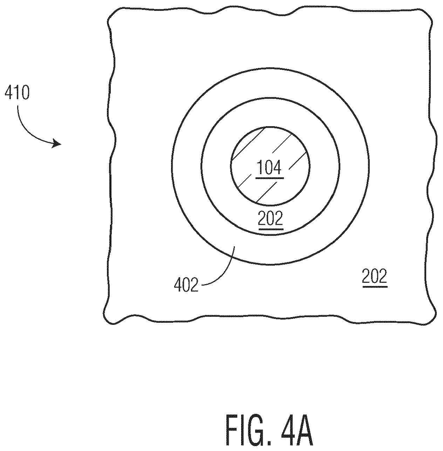

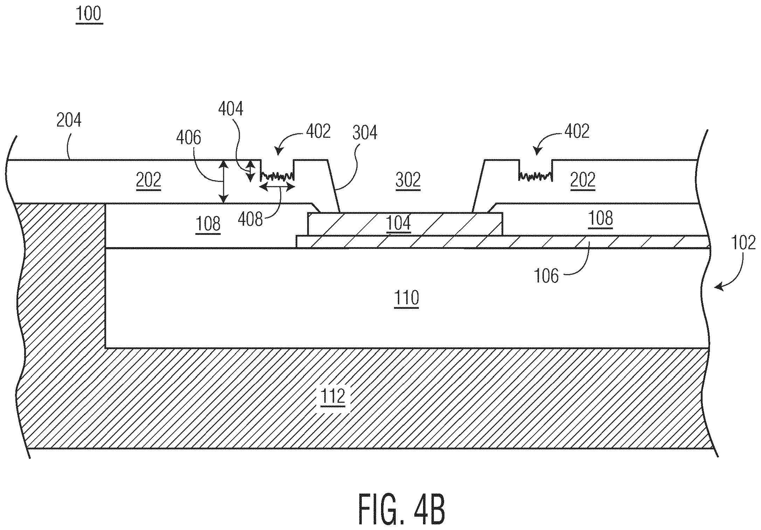

FIG. 4A and FIG. 4B illustrate, in simplified plan and cross-sectional views, the example semiconductor device 100 at a subsequent stage of manufacture in accordance with an embodiment. For example, FIG. 4A depicts a bottom-side-up plan view 410 of the portion of the semiconductor device 100 and FIG. 4B depicts a cross-sectional view corresponding with FIG. 4A. At this stage, a laser ablated trench 402 is formed in the non-conductive layer 202 proximate to a perimeter of the opening 302 and substantially surrounding (e.g., encircling) the opening.

In this embodiment, the laser ablated trench 402 is formed at a first (e.g., outermost) surface 204 of the non-conductive layer 202. The laser ablated trench 402 is configured to enhance adhesion between the non-conductive layer 202 and the UBM structure formed at a subsequent stage, for example. The laser ablated trench 402 may be formed by way of a low energy laser, for example, configured to remove material at the first surface 204 of the non-conductive layer 202. By forming the laser ablated trench 402 in this manner, a bottom surface of the trench may result with a substantially roughened texture configured for improved adhesion. The laser ablated trench 402 may be formed having desired cross-sectional depth 404 and width 408 dimensions sufficient for enhancing adhesion between the non-conductive layer 202 and the subsequent UBM. For example, it may be desirable to form the laser ablated trench 402 with a predetermined cross-sectional depth 404 in a range of 25% to 50% of the thickness dimension 406 of the non-conductive layer 202. In this embodiment, a portion of the first surface 204 of the non-conductive layer 202 remains between the inner side wall of the laser ablated trench 402 and the perimeter of the opening 302.

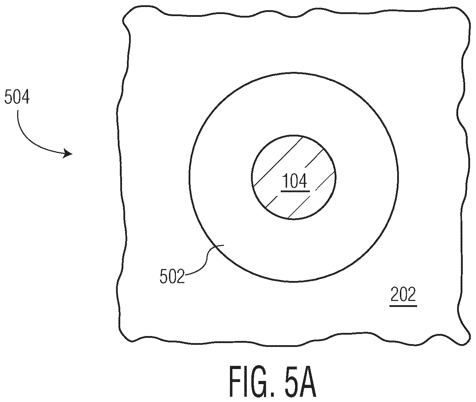

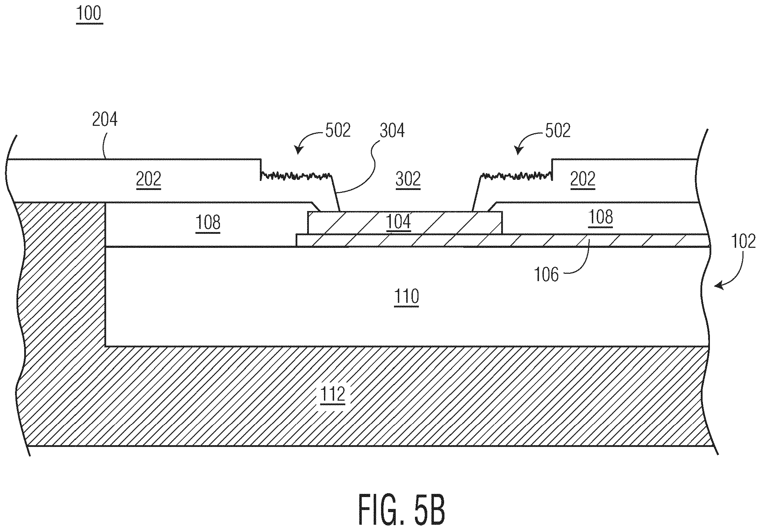

FIG. 5A and FIG. 5B illustrate, in simplified plan and cross-sectional views, the example semiconductor device 100 at an alternate stage of manufacture in accordance with an embodiment. For example, FIG. 5A depicts a bottom-side-up plan view 504 of the portion of the semiconductor device 100 and FIG. 5B depicts a cross-sectional view corresponding with FIG. 5A. At this stage, a laser ablated trench 502 is formed in the non-conductive layer 202 extending into the opening 302 and substantially surrounding (e.g., encircling) the opening. The laser ablated trench 502 depicted in FIG. 5A and FIG. 5B is an alternative to the laser ablated trench 402 depicted in FIG. 4A and FIG. 4B.

In this embodiment, the laser ablated trench 502 is formed at the first surface 204 of the non-conductive layer 202 in a somewhat similar manner as the laser ablated trench 402. However, the laser ablated trench 502 includes an outer sidewall without an inner sidewall thus having a cross-sectional depth continuous from the outer sidewall through to the opening 302 as depicted in FIG. 5B. By forming the laser ablated trench 502 in this manner, a larger bottom surface area of the trench results with the substantially roughened texture configured for further improved adhesion between non-conductive layer 202 and the subsequent UBM structure. In this embodiment, no portion of the first surface 204 of the non-conductive layer 202 remains between the outer sidewall of the laser ablated trench 502 and the opening 302.

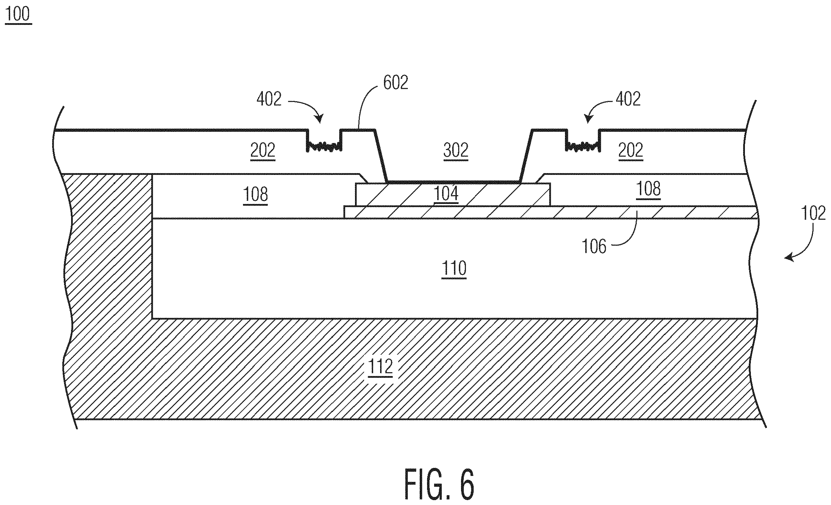

FIG. 6 illustrates, in a simplified cross-sectional view, the example semiconductor device 100 at a subsequent stage of manufacture in accordance with an embodiment. At this stage of manufacture, a seed layer 602 is formed over the non-conductive layer 202 and exposed bond pad 104 to expose a portion of the surface of the bond pad. In this embodiment, the seed layer 602 is sputtered, deposited, or otherwise applied on the first surface 204 of the non-conductive layer 202, the sidewalls and bottom surface of the laser ablated trench 402, the sidewalls of the opening 302, and the exposed surface of the bond pad 104. The seed layer 602 may be formed as a relatively thin layer (e.g., ~0.1-0.5 microns) and may include titanium, tungsten, palladium, copper, or suitable combinations thereof suitable for plating an UBM structure with a conductive material such as copper. The seed layer 602 may also serve as a barrier layer to avoid diffusion into the bond pad 104 and enhance adhesion to underlying non-conductive layer 202.

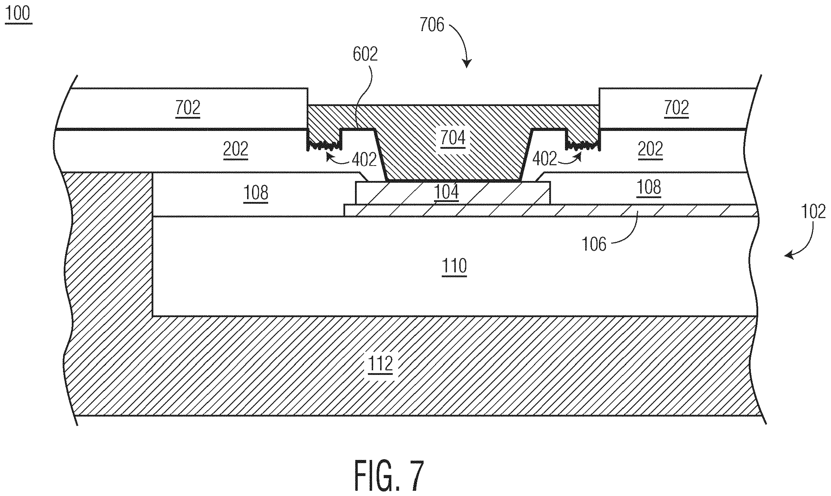

FIG. 7 illustrates, in a simplified cross-sectional view, the example semiconductor device 100 at a subsequent stage of manufacture in accordance with an embodiment. At this stage of manufacture, a conductive layer 704 is formed on the seed layer 602 to form the UBM structure 706. In this embodiment, a plating mask layer 702 is applied on the seed layer 602 and patterned to define predetermined areas to be plated (e.g., UBM structures). After the plating mask layer 702 is patterned, the semiconductor device 100 is subjected to a plating process. In this embodiment, the conductive layer 704 includes a copper material and is formed by utilizing the seed layer 402 in a copper plating process. The copper plating process may be characterized as an electroless process or an electroplating process. The plated conductive layer 704 forms a conformal conductive layer over the exposed bond pad 104 as well as the laser ablated trench 402 of the UBM structure 706. In some embodiments, the conductive layer 704 may be incorporated a redistribution layer (RDL) of a package substrate.

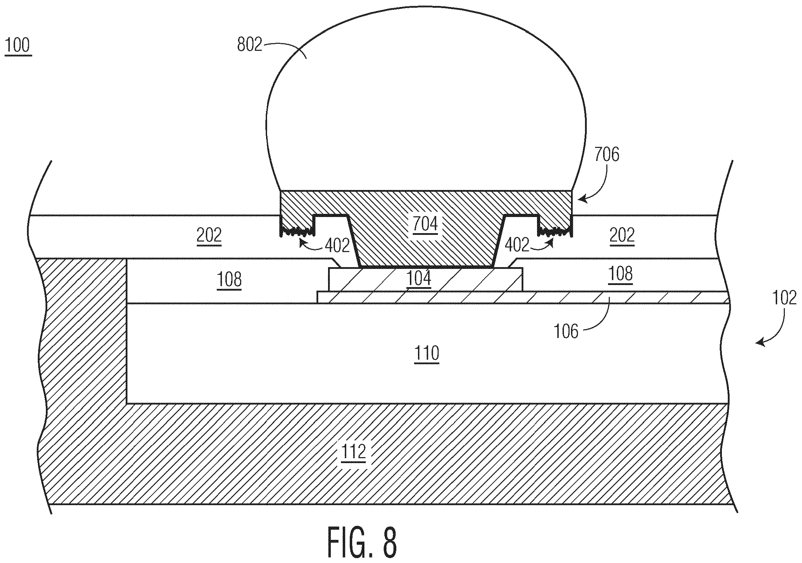

FIG. 8 illustrates, in a simplified cross-sectional view, the example semiconductor device 100 at a subsequent stage of manufacture in accordance with an embodiment. At this stage of manufacture, a conductive connector 802 (e.g., solder ball) is attached to the UBM structure 706. The conductive connector 802 is placed onto the UBM structure 706 and reflowed. A flux material may be applied to the surface of UBM structure 706 before placing the conductive connector 802 onto the UBM structure to improve wetting and adhesion. In this embodiment, the conductive connector 802 is formed as a solder ball. In other embodiments, the conductive connector 802 may be in the form of a suitable conductive structure such as a solder bump, gold stud, copper pillar, or the like. After attaching the conductive connector 802 to the UBM structure 706, an anti-tarnish or preservative material may be applied over exposed portions of the conductive layer 704. The anti-tarnish or preservative material may bond with the conductive layer 704 in a manner that protects exposed surfaces of the conductive layer 704 from oxidation or corrosion, for example.

In one embodiment, there is provided, a method including forming a non-conductive layer over an active side of a semiconductor die, the semiconductor die partially encapsulated with an encapsulant; forming an opening in the non-conductive layer, the opening exposing a portion of a bond pad of the semiconductor die; forming a laser ablated trench at a first surface of the non-conductive layer proximate to a perimeter of the opening, a bottom surface of the laser ablated trench substantially roughened; and plating to form an under-bump metallization (UBM) structure over the bond pad and laser ablated trench. The laser ablated trench may be formed at least partially surrounding the perimeter of the opening. The substantially roughed bottom of the laser ablated trench may be continuous into the opening. The method may further include affixing a conductive connector to the UBM structure. The method may further include after forming the laser ablated trench, applying a seed layer on the non-conductive layer and the exposed portion of the bond pad. The method may further include patterning a mask layer on the seed layer before plating to form the UBM structure. The method may further include after plating to form the UBM structure, removing the mask layer and the seed layer portion underlying the mask layer. The laser ablated trench may have a depth in a range of 25% to 50% of a thickness of the non-conductive layer. The opening may be formed by way of laser ablation at a higher energy level than that of the formation of the laser ablated trench.

In another embodiment, there is provided, a semiconductor device including a semiconductor die partially encapsulated with an encapsulant, an active side of the semiconductor die exposed and substantially coplanar with a first surface of the encapsulant; a non-conductive layer formed over the active side of the semiconductor die and the first surface of the encapsulant; an opening formed in the non-conductive layer exposing a portion of a bond pad of the semiconductor die; a laser ablated trench formed at a first surface of the non-conductive layer proximate to a perimeter of the opening, a bottom surface of the laser ablated trench substantially roughened; and an under-bump metallization (UBM) structure formed over the bond pad and laser ablated trench. The laser ablated trench may be formed at least partially surrounding the perimeter of the opening. The substantially roughed bottom of the laser ablated trench may be continuous into the opening. The semiconductor device may further include a conductive connector affixed to the UBM structure, the conductive connector configured for connection to a printed circuit board. The non-conductive layer may be formed as an Ajinomoto build-up film (ABF). The laser ablated trench may have a depth in a range of 25% to 50% of a thickness of the non-conductive layer.

In yet another embodiment, there is provided, a method including forming a non-conductive layer over an active side of a semiconductor die and a first surface of an encapsulant, the encapsulant partially encapsulating the semiconductor die; forming a laser ablated opening in the non-conductive layer exposing a portion of a bond pad of the semiconductor die; forming a laser ablated trench at a first surface of the non-conductive layer proximate to a perimeter of the opening, a bottom surface of the laser ablated trench substantially roughened; and plating to form an under-bump metallization (UBM) structure over the bond pad and laser ablated trench. The laser ablated trench may be formed at least partially surrounding the perimeter of the laser ablated opening. The substantially roughed bottom of the laser ablated trench may be continuous into the laser ablated opening. The method may further include affixing a conductive connector to the UBM structure. The laser ablated trench may have a depth in a range of 25% to 50% of a thickness of the non-conductive layer.

By now, it should be appreciated that there has been provided a semiconductor device with an under-bump metallization (UBM) structure. The semiconductor device includes a semiconductor die partially encapsulated with an encapsulant. An active side of the semiconductor die is exposed and coplanar with a surface of the encapsulant. A non-conductive layer is formed over an active side of semiconductor die and surface of the encapsulant. An opening in the non-conductive layer is formed to expose a bond pad. A laser ablated trench is formed at the surface of the non-conductive layer near a perimeter of the opening. By using a low energy laser to form the trench, a bottom surface of the trench is roughened. The UBM structure is formed by plating over the trench and exposed pad region. The rough texture of the trench allows for superior adhesion of the UBM structure at the trench. By forming the UBM in this manner, potential stress induced delamination is minimized thus improving overall reliability of the semiconductor device.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming a non-conductive layer over an active side of a semiconductor die, the semiconductor die partially encapsulated with an encapsulant;
forming an opening in the non-conductive layer, the opening exposing a portion of a bond pad of the semiconductor die;
forming a laser ablated trench at a first surface of the non-conductive layer proximate to a perimeter of the opening, a bottom surface of the laser ablated trench being substantially roughened; and
plating to form an under-bump metallization, UBM, structure over the bond pad and laser ablated trench.

2. The method of claim 1, wherein the laser ablated trench is formed at least partially surrounding the perimeter of the opening.

3. The method of claim 1 or 2, wherein the substantially roughed bottom of the laser ablated trench is continuous into the opening.

4. The method of any preceding claim, further comprising affixing a conductive connector to the UBM structure.

5. The method of any preceding claim, further comprising after forming the laser ablated trench, applying a seed layer on the non-conductive layer and the exposed portion of the bond pad.

6. The method of claim 5, further comprising patterning a mask layer on the seed layer before plating to form the UBM structure.

7. The method of claim 6, further comprising after plating to form the UBM structure, removing the mask layer and the seed layer portion underlying the mask layer.

8. The method of any preceding claim, wherein the laser ablated trench has a depth in a range of 25% to 50% of a thickness of the non-conductive layer.

9. The method of any preceding claim, wherein the opening is formed by way of laser ablation at a higher energy level than that of the formation of the laser ablated trench.

10. A semiconductor device comprising:
a semiconductor die partially encapsulated with an encapsulant, an active side of the semiconductor die exposed and substantially coplanar with a first surface of the encapsulant;
a non-conductive layer formed over the active side of the semiconductor die and the first surface of the encapsulant;
an opening formed in the non-conductive layer exposing a portion of a bond pad of the semiconductor die;
a laser ablated trench formed at a first surface of the non-conductive layer proximate to a perimeter of the opening, a bottom surface of the laser ablated trench being substantially roughened; and
an under-bump metallization, UBM, structure formed over the bond pad and laser ablated trench.

11. The semiconductor device of claim 10, wherein the laser ablated trench is formed at least partially surrounding the perimeter of the opening.

12. The semiconductor device of claim 10 or 11, wherein the substantially roughed bottom of the laser ablated trench is continuous into the opening.

13. The semiconductor device of any of claims 10 to 12, further comprising a conductive connector affixed to the UBM structure, the conductive connector configured for connection to a printed circuit board.

14. The semiconductor device of any of claims 10 to 13, wherein the non-conductive layer is formed as an Ajinomoto build-up film, ABF.

15. The semiconductor device of any of claims 10 to 14, wherein the laser ablated trench has a depth in a range of 25% to 50% of a thickness of the non-conductive layer.

## Patentansprüche

1. Verfahren, Folgendes umfassend:
Ausbilden einer nichtleitenden Schicht über einer aktiven Seite eines Halbleiter-Chips, wobei der Halbleiter-Chip teilweise mit einem Verkapselungsmittel verkapselt ist;
Ausbilden einer Öffnung in der nichtleitenden Schicht, wobei die Öffnung einen Abschnitt einer Bondkontaktfläche des Halbleiter-Chips freilegt;
Ausbilden eines mit Laser abgetragenen Grabens an einer ersten Oberfläche der nichtleitenden Schicht nahe eines Umfangs der Öffnung, wobei eine Bodenfläche des mit Laser abgetragenen Grabens im Wesentlichen aufgeraut ist; und
Beschichten, um eine Under-Bump-Metallisierungsstruktur, UBM-Struktur, über der Bondkontaktfläche und dem mit Laser abgetragenen Graben auszubilden.

2. Verfahren nach Anspruch 1, wobei der mit Laser abgetragene Graben ausgebildet ist, dass er den Umfang der Öffnung mindestens teilweise umgibt.

3. Verfahren nach Anspruch 1 oder 2, wobei der im Wesentlichen aufgeraute Boden des mit Laser abgetragenen Grabens kontinuierlich in die Öffnung ist.

4. Verfahren nach einem der vorhergehenden Ansprüche, weiterhin umfassend Befestigen eines leitfähigen Verbinders an der UBM-Struktur.

5. Verfahren nach einem der vorhergehenden Ansprüche, weiterhin umfassend, nach Ausbilden des mit Laser abgetragenen Grabens, Aufbringen einer Keimschicht auf die nichtleitende Schicht und den freiliegenden Abschnitt der Bondkontaktfläche.

6. Verfahren nach Anspruch 5, weiterhin umfassend Strukturieren einer Maskenschicht auf der Keimschicht vor dem Beschichten, um die UBM-Struktur auszubilden.

7. Verfahren nach Anspruch 6, weiterhin umfassend, nach Beschichten, um die UBM-Struktur auszubilden, Entfernen der Maskenschicht und des Keimschichtabschnitts, der unter der Maskenschicht liegt.

8. Verfahren nach einem der vorhergehenden Ansprüche, wobei der mit Laser abgetragene Graben eine Tiefe in einem Bereich von 25 % bis 50 % einer Dicke der nichtleitenden Schicht aufweist.

9. Verfahren nach einem der vorhergehenden Ansprüche, wobei die Öffnung ausgebildet wird durch Abtragung mit Laser bei einem höheren Energieniveau als dem der Ausbildung des mit Laser abgetragenen Grabens.

10. Halbleiterbauelement, Folgendes umfassend:
einen Halbleiter-Chip, der teilweise mit einem Verkapselungsmittel verkapselt ist, wobei eine aktive Seite des Halbleiter-Chips freiliegt und im Wesentlichen koplanar zu einer ersten Oberfläche des Verkapselungsmittels ist;
eine nichtleitende Schicht, die über der aktiven Seite des Halbleiter-Chips und der ersten Oberfläche des Verkapselungsmittels ausgebildet ist;
eine Öffnung, die in der nichtleitenden Schicht ausgebildet ist und die einen Abschnitt einer Bondkontaktfläche des Halbleiter-Chips freilegt;
ein mit Laser abgetragener Graben, der an einer ersten Oberfläche der nichtleitenden Schicht nahe eines Umfangs der Öffnung ausgebildet ist, wobei eine Bodenfläche des mit Laser abgetragenen Grabens im Wesentlichen aufgeraut ist; und
eine Under-Bump-Metallisierungsstruktur, UBM-Struktur, die über der Bondkontaktfläche und dem mit Laser abgetragenen Graben ausgebildet ist.

11. Halbleiterbauelement nach Anspruch 10, wobei der mit Laser abgetragene Graben ausgebildet ist, dass er den Umfang der Öffnung mindestens teilweise umgibt.

12. Halbleiterbauelement nach Anspruch 10 oder 11, wobei der im Wesentlichen aufgeraute Boden des mit Laser abgetragenen Grabens kontinuierlich in die Öffnung ist.

13. Halbleiterbauelement nach einem der Ansprüche 10 bis 12, weiterhin umfassend einen leitfähigen Verbinder, der an der UBM-Struktur befestigt ist, wobei der leitfähige Verbinder zur Verbindung mit einer gedruckten Leiterplatte eingerichtet ist.

14. Halbleiterbauelement nach einem der Ansprüche 10 bis 13, wobei die nichtleitende Schicht als ein Ajinomoto-Aufbaufilm, ABF, ausgebildet ist.

15. Halbleiterbauelement nach einem der Ansprüche 10 bis 14, wobei der mit Laser abgetragene Graben eine Tiefe in einem Bereich von 25 % bis 50 % einer Dicke der nichtleitenden Schicht aufweist.

## Revendications

1. Procédé comprenant :
la formation d'une couche non conductrice sur un côté actif d'une puce semi-conductrice, la puce semi-conductrice étant partiellement encapsulée par un encapsulant ;
la formation d'une ouverture dans la couche non conductrice, l'ouverture exposant une partie d'un plot de connexion de la puce semi-conductrice ;
la formation d'une tranchée par ablation laser à une première surface de la couche non conductrice à proximité d'un périmètre de l'ouverture, une surface inférieure de la tranchée formée par ablation laser étant rendue sensiblement rugueuse ; et
un dépôt pour former une structure de métallisation sous bosse, UBM, sur le plot de connexion et la tranchée formée par ablation laser.

2. Procédé selon la revendication 1, dans lequel la tranchée formée par ablation laser est formée au moins partiellement autour du périmètre de l'ouverture.

3. Procédé selon la revendication 1 ou 2, dans lequel le fond rendu sensiblement rugueux de la tranchée formée par ablation laser se prolonge dans l'ouverture.

4. Procédé selon une quelconque revendication précédente, comprenant en outre la fixation d'un connecteur conducteur à la structure UBM.

5. Procédé selon une quelconque revendication précédente, comprenant en outre, après la formation de la tranchée par ablation laser, l'application d'une couche de germination sur la couche non conductrice et la partie exposée du plot de connexion.

6. Procédé selon la revendication 5, comprenant en outre le modelage d'une couche de masquage sur la couche de germination avant le revêtement pour former la structure UBM.

7. Procédé selon la revendication 6, comprenant en outre, après le revêtement pour former la structure UBM, le retrait de la couche de masquage de la partie de la couche de germination sous-jacente à la couche de masquage.

8. Procédé selon une quelconque revendication précédente, dans lequel la tranchée formée par ablation laser a une profondeur dans une plage de 25 % à 50 % d'une épaisseur de la couche non conductrice.

9. Procédé selon une quelconque revendication précédente, dans lequel l'ouverture est formée par ablation laser à un niveau d'énergie supérieur à celui de la formation de la tranchée par ablation laser.

10. Dispositif semi-conducteur comprenant :
une puce semi-conductrice partiellement encapsulée par un encapsulant, un côté actif de la puce semi-conductrice étant exposé et sensiblement coplanaire avec une première surface de l'encapsulant ;
une couche non conductrice formée sur le côté actif de la puce semi-conductrice et la première surface de l'encapsulant ;
une ouverture formée dans la couche non conductrice exposant une partie d'un plot de connexion de la puce semi-conductrice ;
une tranchée formée par ablation laser à une première surface de la couche non conductrice à proximité d'un périmètre de l'ouverture, une surface inférieure de la tranchée formée par ablation laser étant rendue sensiblement rugueuse ; et
une structure de métallisation sous bosse, UBM, formée sur le plot de connexion et la tranchée formée par ablation laser.

11. Dispositif semi-conducteur selon la revendication 10, dans lequel la tranchée formée par ablation laser est formée au moins partiellement autour du périmètre de l'ouverture.

12. Dispositif semi-conducteur selon la revendication 10 ou 11, dans lequel le fond rendu sensiblement rugueux de la tranchée formée par ablation laser se prolonge dans l'ouverture.

13. Dispositif semi-conducteur selon l'une quelconque des revendications 10 à 12, comprenant en outre un connecteur conducteur fixé à la structure UBM, le connecteur conducteur étant conçu pour une connexion à une carte de circuit imprimé.

14. Dispositif semi-conducteur selon l'une quelconque des revendications 10 à 13, dans lequel la couche non conductrice est formée comme un film de construction Ajinomoto, ABF.

15. Dispositif semi-conducteur selon l'une quelconque des revendications 10 à 14, dans lequel la tranchée formée par ablation laser a une profondeur dans une plage de 25 % à 50 % d'une épaisseur de la couche non conductrice.
